(19) Europäisches Patentamt
European Patent Office
Office européen des brevets

(11) **EP 2 898 108 B1**

(12) **EUROPÄISCHE PATENTSCHRIFT**

(45) Veröffentlichungstag und Bekanntmachung des Hinweises auf die Patenterteilung:
**18.07.2018 Patentblatt 2018/29**

(21) Anmeldenummer: **13763189.1**

(22) Anmeldetag: **16.09.2013**

(51) Int Cl.:
*C23C 14/00* (2006.01)     *C23C 14/10* (2006.01)
*C23C 14/56* (2006.01)

(86) Internationale Anmeldenummer:
**PCT/EP2013/002778**

(87) Internationale Veröffentlichungsnummer:
**WO 2014/044378 (27.03.2014 Gazette 2014/13)**

(54) **VORRICHTUNG ZUR HERSTELLUNG EINER KLEBEFREIEN GASBARRIEREFOLIE MIT EINER KERAMISCHEN BARRIERESCHICHT**

DEVICE FOR PRODUCING AN ADHESIVE-FREE GAS BARRIER FILM WITH A CERAMIC BARRIER LAYER

DISPOSITIF POUR FABRIQUER UN FILM ANTI-ADHÉSIF FORMANT BARRIÈRE AUX GAZ MUNIE D'UNE COUCHE BARRIÈRE CÉRAMIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **19.09.2012 DE 102012018525**
**19.09.2012 US 201261702884 P**

(43) Veröffentlichungstag der Anmeldung:
**29.07.2015 Patentblatt 2015/31**

(73) Patentinhaber: **Fresenius Medical Care Deutschland GmbH**
**61352 Bad Homburg (DE)**

(72) Erfinder:
• **HANSEL, Dietmar**
**66564 Ottweiler (DE)**
• **HEILMANN, Klaus**
**66606 St. Wendel (DE)**
• **SCHULTE, Thomas**
**66606 St. Wendel (DE)**
• **PFEIL, Tobias**
**66629 Freisen (DE)**
• **BREITER, Björn**
**66386 St. Ingbert (DE)**

(74) Vertreter: **Herrmann, Uwe**
**Lorenz Seidler Gossel**
**Rechtsanwälte Patentanwälte**
**Partnerschaft mbB**
**Widenmayerstraße 23**
**80538 München (DE)**

(56) Entgegenhaltungen:
**EP-A1- 0 640 474    DE-A1- 3 300 411**
**US-A- 3 442 686    US-A- 5 084 356**
**US-A- 5 085 904**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die vorliegende Erfindung betrifft eine Vorrichtung zur Herstellung einer kleberfreien Gasbarrierefolie mit einer vorzugsweise keramischen Barriereschicht, ein Verfahren zur Herstellung einer kleberfreien Gasbarrierefolie mit einer vorzugsweise keramischen Barriereschicht, eine mehrschichtige Gasbarrierefolie, eine Verwendung einer Vorrichtung zur Herstellung einer kleberfreien Gasbarrierefolie sowie ein Disposable.

Sperrschichtfolien sind beispielsweise erforderlich zur Verpackung der mit Bicarbonat gepufferten Dialyselösungen, die zunehmend sowohl in der Peritoneal- als auch in der Akutdialyse eingesetzt werden. Des Weiteren werden diese mit Gassperrschichten ausgestatteten Folientypen auch als Container für enterale und parenterale Nährlösungen verwendet.

In herkömmlichen Verfahren zur keramischen Beschichtung von Folienbahnen wird eine auf eine Hülse aufgewickelte Trägerfolie in eine Beschichtungsanlage gegeben, die anschließend evakuiert wird. Wie in der DE 42 21 800 gezeigt ist, wird die Folie in dieser Beschichtungsanlage abgerollt, über verschiedene Führungswalzen an einer Beschichtungsapparatur vorbeigeführt und innerhalb der Anlage wieder zu einem Folienwickel aufgespult. Unter Folienwickel wird in diesem Zusammenhang die auf eine Hülse aufgewickelte oder aufgespulte Folie verstanden. Die Beschichtungsprozesse erfordern eine Evakuierung der gesamten Anlage. Allgemein reagieren so hergestellte keramische Barriereschichten ohne weitere Schutzschicht empfindlich auf äußere Einwirkung wie z. B. Zugspannungen, die eine Foliendehnung bewirken oder Knickbeanspruchungen bei der das Folienmaterial ebenfalls gedehnt wird.

Auch die EP 0 640 474 A1 offenbart die Herstellung einer Verbundfolie, bei der eine keramische Schicht auf eine Trägerfolie mittels Sputtern aufgetragen wird. Es handelt sich dabei um ein Verfahren, bei dem in einer Hochvakuum-Verdampfungsanlage eine mittels Sputtern keramisch beschichtete Basisfolie und die Deckschicht mit einer Verbundfolie verbunden werden.

Keramische oder glasartige Barriereschichten zeigen in den gebräuchlichen Materialdicken ein sprödes Verhalten, so dass Foliendehnungen zu Rissbildung in der Barriereschicht führen können. Die Folge kann eine erhebliche Verschlechterung der Barrierewirkung sein. Gebräuchlich sind daher Trägerfolien, die gegenüber einer Zugbeanspruchung eine hohe Widerstandskraft aufweisen. Wie in der DE 42 21 800 dargestellt, lässt sich dies am Elastizitätsmodul ablesen. Materialien aus Polyester sind daher zurzeit ein bevorzugtes Material, um als Trägermaterial verwendet zu werden.

In weiteren Prozessen wird die geträgerte Gasbarriere-Folie durch Kaschierprozesse oder Laminierungsverfahren mit einer Basisfolie verbunden. Die Basisfolie trägt dann weiteren Anforderungen, die an den gesamten Folienverbund gestellt werden, Rechnung, z. B. Schichtdicke, Schlagzähigkeit, Transparenz, mechanische Belastbarkeit, thermische Belastbarkeit, Schweißbarkeit usw. sind Anforderungen, die im Folienverbund durch den Teil der Basisfolie im Wesentlichen erfüllt werden.

Insbesondere für die Herstellung von pharmazeutischen Beuteln für z. B. Infusionslösungen, sind Folien mit einem besonderen Eigenschaftsprofil gefragt. Die Folien solcher Beutel müssen transparent sein, um die darin befindliche Lösung optisch bewerten zu können, sie müssen sterilisationsfest bei Temperaturen von 121 °C sein, die Folie muss schlagfest sein und der Beutel muss erhöhten Drücken standhalten können und die Schweißnähte müssen entsprechende Festigkeiten unter mechanischer Einwirkung aufweisen können. Für die Herstellung von Mehrkammerbeuteln werden peelbar verschweißbare Folien benötigt, d. h. Folien, die unter verringerter Schweißtemperatur eine semipermanente, lösbare Verbindung der Folien eingehen.

Unter der Peelbarkeit einer Fügeverbindung wird die Verbindung zweier Fügepartner verstanden, die lösbar sind, ohne dass einer der Fügepartner vollständig zerstört wird. Bei peelbaren Verbindungen zweier Folien sind die Folien in der Regel entlang ihrer ursprünglichen Grenzfläche lösbar. Es kann in speziellen Fällen, in denen Folien aus einem Mehrschichtverbund aufgebaut sind, unter Peelverbindungen auch eine Delamination einer der beiden Folien verstanden werden, solange der Folienverbund nicht vollständig gebrochen wird. Peelverbindungen zwischen Folien werden durch eingestellte Wärmeverbindungen oder durch Haftvermittler hergestellt. Angaben zu Peelverbindungen können den ASTM Normen F88-94 oder D 1876-01 entnommen werden.

Für die Herstellung von Barrierefolien mit keramischen Barrierematerialien werden geläufigerweise verstreckte Polyesterfolien oder verstreckte Polyamidfolien als Trägerfolie verwendet. Das Maß für die Verstreckung einer Folie ist das Reckverhältnis von unverstreckter zu verstreckter Folie. Verstreckte Folien können ein Reckverhältnis von 1:10 aufweisen. In Längsreckmaschinen erfolgt die Längsorientierung durch unterschiedlich schnell angetriebene Abzugswalzen. Bei der anschließenden Querreckung wird die Folie beidseitig durch sogenannte Kluppen gehalten und unter Wärmeeinwirkung in die Breite verstreckt. Längs- und querverstreckte Folien werden auch biaxial orientierte Folien genannt. Unverstreckte Folien sind demgegenüber nur minimal verstreckt durch das Abziehen der Kunststoffschmelze während des Extrusionsvorgangs. Verstreckte Folien mit hohem Reckverhältnis weisen für die Beschichtung mit keramischen Barrierematerialien in der Regel gute mechanische Steifigkeitswerte auf. Verstreckte Folien sind aus technischer Sicht jedoch nicht für alle Anwendungen optimal. Unter Wärmeeinwirkung neigen verstreckte Polymermaterialien zum Schrumpfen. Beim Sterilisationsprozess von Lösungsbeuteln aus verstreckten Folienmaterialien können daher Materialveränderungen auftreten und eine Verschlechterung der Barrierewirkung verursachen. Andererseits werden verstreckte Folien durch einen weiteren thermischen Verfahrensschritt unter Spannung in entsprechenden Anlagen thermisch entspannt oder thermofixiert. Auf molekularer Ebene wird eine Relaxierung der polymeren Kettensegmente in einen in einen entropisch begünstigten Zustand erreicht, so dass bei thermischer Belastung der Folien keine oder nur geringen Schrumpfungen des Materials zu erwarten sind. Solcherart verstreckte und thermofixierte Folienmaterialien werden unter anderem auch für die Herstellung von hitzesterilisierbaren pharmazeutischen Lösungsbeutel verwendet. Allerdings werden so für die Herstellung verstreckter Folien in der Herstellung einer Gasbarrierefolie zusätzliche Verfahrensschritte mit anlagen- und energieaufwendigen Aufbauten notwendig.

Weiterhin werden die handelsüblich hergestellten polyester- oder polyamidgeträgerten keramischen Barrierefolien durch einen weiteren Verfahrensschritt der Lamination mit einer Basisfolie oder Deckfolie zu einem gebrauchsfertigen Folienverbund gefertigt. In Laminierungsprozessen wird zwischen Klebstoffen und Haftvermittler unterschieden. Klebstoffe sind niedermolekulare Materialien, die die Haftung zwischen zwei Laminatschichten verursachen. Als Haftvermittler werden hochmolekulare polymere Stoffe verstanden, wie sie beim Extrusionskaschieren eingesetzt werden. Als Haftvermittler kommen z.B. modifizierte Polymere zum Einsatz. Maleinsäureanhydrid modifizierte Polypropylene werden z.B. unter dem Handelsnamen "Admer" als Haftvermittler verwendet. Maleinsäureanhydridmodifizierte Styrolblock Copolymere sind z.B. unter den Polymertypen "Kraton" Als Haftvermittler bekannt. Ebenso werden Carboxy-Oxazolin- Glycidylgruppen modifizierte Polymere als Haftvermittler verwendet. Diese hochmolekularen Haftvermittler sind gegen Migrationsvorgängen weitgehend inert. D.h. dass die Bestandteile dieses Haftmaterials unter Anwendungsbedingungen weitestgehend nicht mobilisierbar sind. Die Migration von Bestandteilen durch den Folienverbund an die Oberfläche der Folie und eine anschließende Kontamination des Verpackungsgutes ist minimiert.

Bei Klebstoffen dagegen können niedrigmolekulare Bestandteile des Klebstoffes durch den Folienverbund migrieren und insbesondere bei medizinischen Anwendungen zu nicht zulässigen Kontaminationen der mit der Folie in Kontakt stehenden Flüssigkeiten führen. Klebstoffen sind daher zur Verwendung in Verpackungen pharmazeutischer Produkte nicht unproblematisch. Aus regulatorischer Sicht werden Folienverbunde mit Klebstoffen für die Verpackung von Arzneimitteln zunehmend kritisch angesehen

In der Regel werden polyester- oder polyamidgeträgerte keramische Barrierefolien durch Klebstoffe mit einer Trägerfolie kaschiert. Die Klebevermittlung erfolgt zwischen keramischer Barriereschicht und der Trägerfolie. Diese Art der Kaschierung erfordert zum Aufbau des Gasbarriere Folienverbundes einen zusätzlichen separaten Prozessschritt, was nachteilig ist.

Bisherige Prozesse zur Herstellung von keramischen Gasbarrierefolien folgen einem Batchverfahren. Dazu wird eine bereits hergestellte verstreckte Trägerfolie, auf einer Hülse zu einem Folienwickel aufwickelt und in eine Beschichtungskammer eingeschleust. Darin wird die Trägerfolie abgewickelt einem Beschichtungsprozess unterworfen und von einen weiteren Aufnahmehülse zu einem Folienwickel aufgenommen. Diese Prozesse erfordern einen hohe Anlagen- und Prozesstechnischen Aufwand. Nachteilig sind hohe Rüstzeiten, um einen Batchprozess vorzubereiten und abzurüsten. Aus wirtschaftlichen Überlegungen ergibt sich dann die Notwendigkeit, dass möglichst große Folienwickel mit einer großen Fläche der darauf gespeicherten Folie für die Beschichtung verwendet werden, um den Aufwand der Rüstzeiten, gegenüber der Menge der zu beschichtenden Folie gering zu halten. Dies erfordert in der Folge wiederum einen hohen anlagentechnischen Aufwand, da größere Beschichtungskammern bereitgestellt werden müssen, was diese Verfahren nachteilig macht. Dokumente US5085904, US3442686, US5084356 offenbaren Verfahren zur Herstellung einer kleberfreien Gasbarrierefolie durch die Verwendung einer Vakuumbeschichtungskammer gefolgt durch Auftragen einer Kunststoffschmelze außerhalb der Beschichtungskammer. Es besteht somit gegenüber dem Stand der Technik das Bedürfnis einen keramischen Gasbarrieren-Folienverbund für die Produktion von medizinischen Lösungsbeuteln herzustellen, der frei von Klebstoffen oder Neben- und Abbauprodukten der Klebstoffe ist und für dessen Herstellung auf die üblichen Kaschierverfahren verzichtet werden kann.

Es ist daher die Aufgabe der vorliegenden Erfindung, eine Vorrichtung, ein Verfahren, eine Folie sowie eine Verwendung einer Vorrichtung der eingangs genannten Art in vorteilhafter Weise weiterzubilden, insbesondere dahingehend, dass die Fertigung einer Folie vereinfacht und die Eigenschaften der Folie verbessert werden können.

Insbesondere wurde nach einem Herstellverfahren gesucht, wonach auf die Verwendung und Herstellung von energie- und anlagenaufwendigen verstreckten Trägerfolien für die Aufnahme der keramische Barriereschicht verzichtet werden kann. Diese Aufgabe wird erfindungsgemäß gelöst durch eine Vorrichtung mit den Merkmalen des Anspruchs 1. Danach ist vorgesehen, dass eine Vorrichtung zur Herstellung einer kleberfreien Gasbarrierefolie mit einer vorzugsweise keramischen Barriereschicht wenigstens ein Fördermittel zum Fördern einer Folienbahn, wenigstens ein erstes Schleusensystem zum Einschleusen der Folienbahn in eine Beschichtungskammer der Vorrichtung, wenigstens ein erstes Beschichtungsmittel, mittels dessen die Folienbahn durch Abscheiden eines Barrierematerials in der Beschichtungskammer beschichtbar ist, wenigstens ein zweites Schleusensystem zum Ausschleusen der Folienbahn und wenigstens ein zweites Beschichtungsmittel mittels dessen die Folienbahn durch Extrusion einer Kunststoffschmelze und Aufbringen der Kunststoffschmelze auf die Folienbahn beschichtbar ist, umfasst. Vorteilhafte Ausgestaltungen der Vorrichtung sind Gegenstand der Unteransprüche.

Als Fördermittel gelten in diesem Zusammenhang alle technischen Vorrichtung mit denen sich die Folienbahn weiter führen, umlenken, aufwickeln lassen, insbesondere Walzen, Umlenkrollen und Hülsen zum Aufwickeln der Folien.

Durch die Vorrichtung ergibt sich somit der der Erfindung gemeinsame, übergeordnete Vorteil und technische Effekt, dass eine kleberfreie keramische Gasbarriere-Folie unter Verwendung des Prozessschrittes der Extrusionsbeschichtung bereitgestellt werden kann, wodurch die der Erfindung zu Grunde liegende Aufgabenstellung besonders vorteilhaft gelöst wird.

Insbesondere ergibt sich der Vorteil. dass mittels der Vorrichtung eine kleberfreie Gasbarrierefolie hergestellt werden kann, die zuverlässig eine Ausgasung von Gasbestandteilen aus z. B. medizinischen Lösungen aus der kleberfreien Gasbarrierefolie hergestellten Disposables verhindert werden kann.

In diesem Zusammenhang sei beispielhaft auf Bicarbonathaltige Lösungen verwiesen, die zur Abspaltung von Kohlendioxid ($CO_2$) neigen. Gast freigesetztes Kohlendioxid aus der Dialyselösung aus, führt dies zu einem Anstieg des pH-Wertes, was zu einer unerwünschten Fällung von Calciumcarbonat ($CaCO_3$) führen kann.

Neben der zuverlässigen Verhinderung einer Ausgasung von Gasbestandteilen ist es aber durch die Erfindung nunmehr auch möglich, auf Kleberschichten, die bislang die für die Gasbarrierefunktion notwendigen anorganischen, insbesondere keramischen Sperrschichten fixiert haben, zu verzichten. Dies ist vor Allem deshalb besonders vorteilhaft, weil diese Kleberschichten eine Quelle für in die Dialyselösung migrierende Substanzen sein können. Durch die Möglichkeit auf die Kleberschicht zu verzichten wird das Problem dieser potentiell migrierenden Substanzen besonders vorteilhaft vermieden und damit gelöst.

Es ist vorteilhaft, wenn die Beschichtung bei niedrigem Druck stattfindet. Insbesondere ist der Druck in der Beschichtungskammer niedriger als in der die Vorrichtung umgebende Atmosphäre, so dass das Innere der Beschichtungskammer als Niederdruckseite relativ zu der die Vorrichtung umgebende Atmosphäre bezeichnet werden kann. Die die Vorrichtung umgebende Atmosphäre kann diesbezüglich als Hochdruckseite bezeichnet werden, da sie relativ zum vorherrschenden Druck in der Beschichtungskammer einen höheren Druck aufweist. Üblicherweise ist vorgesehen, dass der Druck der Hochdruckseite dem normalen Atmosphärendruck entspricht.

Gegebenenfalls kann vorgesehen sein, dass die zweiten Beschichtungsmittel zum Aufbringen einer Kunststoffschmelze auf die Folienbahn innerhalb der Beschichtungskammer liegen. Insbesondere können aber bei Beschichtungen, die für die ersten Beschichtungsmittel ein Hochvakuum erfordern nicht alle Kunststoffschmelzen gemäß der zweiten Beschichtung sicher auf die Folienbahn aufgebracht werden. Zudem kann in manchen Fällen der anlagentechnische Aufwand für die zweiten Beschichtungsmittel innerhalb der Beschichtungskammer nachteilig hoch sein. In solchen Fällen ist es erforderlich, dass die mit den ersten Beschichtungsmitteln beschichtete Folienbahn aus der Beschichtungskammer durch ein zweites Schleusensystem auf eine Hochdruckseite ausgeschleust wird. Auf der Hochdruckseite kann die Folienbahn durch weitere Fördermittel, wie z.B. Walzen und Umlenkrollen zu den zweiten Beschichtungsmitteln gefördert werden, so dass eine extrudierte Kunststoffschmelze auf die Folienbahn aufgebracht werden kann.

Es hat sich gezeigt, dass wenn die zweite Beschichtung durch die zweiten Beschichtungsmittel inline durchgeführt werden eine Alterung, d.h. chemische Veränderung, der ersten Beschichtung nicht signifikant auftritt. Dadurch kann gewährleistet werden, dass eine Haftung der zweiten Beschichtungsschicht auf der ersten Beschichtungsschicht nicht nachteilig beeinflusst wird.

Es ist vorteilhaft möglich, dass die Vorrichtung wenigstens eine Extrusionsdüse zum Extrudieren wenigstens einer Kunststoffschmelze, wobei aus der Kunststoffschmelze die Folienbahn erhalten wird, und eine oder mehrere Walzen zum Fördern der aus der extrudierten Kunststoffschmelze erhaltenen Folienbahn aufweist.

Des Weiteren kann vorgesehen sein, dass die Folienbahn mit einer Fördergeschwindigkeit von mindestens 3 m/min, insbesondere zwischen 30 m/min bis 45 m/min, weiter insbesondere zwischen 30 bis 300 m/min, oder bis zu 240 m/min oder bis zu 150 m/min und darunter, insbesondere maximal 300 m/min, vorzugsweise maximal bis zu 60 m/min förderbar ist.

Ferner ist möglich, dass das erste und/oder das gegebenenfalls zweite Schleusensystem wenigstens eine Walzenschleuse und/oder wenigstens eine Schlitzschleuse aufweist.

Darüber hinaus ist denkbar, dass für das erste oder das gegebenenfalls zweite Schleusensystem mehrere Absaugkammern vorgesehen sind, die jeweils eine Druckstufe ausbilden. Absaugkammern können sich jeweils zwischen den einzelnen Schleusen befinden. Dabei kann nach den Absaugkammern des ersten Schleusensystems wenigstens eine oder mehrere Entgasungskammern vorgesehen sein. Durch die Entgasungskammer ergibt sich der Vorteil, dass eine Entfernung von flüchtigen Teilen aus der Folie stattfinden kann.

Zwischen den einzelnen Schleusen befindliche Absaugkammer, können mit Pumpenmitteln je nach Vakuumanforderung, z.B. einer Drehschieberpumpe, einer Wälzkolbenpumpe oder einer Turbopumpe ausgestattet sein.

Das Vakuum kann auch stufenweise durch mehrere Absaugstufen angelegt werden, so dass das Vakuum im gesamten Schleusensystem durch ein Druckgefälle von Atmosphärendruck auf einen bevorzugten Enddruck von $10^{-6}$ mbar entsteht.

Insbesondere ist vorgesehen, dass mit der Beschichtungskammer und den ersten Beschichtungsmitteln eine Barriereschicht auf die Folienbahn abscheidbar ist. Es besteht das Bedürfnis bei Folien für die Verpackung von pharmazeutischen Füllgütern, dass die Barriereschicht eine Barrierewirkung für den Durchtritt von Gasen wie z.B. Sauerstoff, Kohlendioxid, Wasserdampf aufweist. Hervorragende Barrierewirkung sind anorganischen Beschichtungsmaterialien zuzuschreiben, wie z.B. durch Abscheidung von Metallen oder keramischen Materialien auf der Folienbahn zu erzielen sind. Für eine Beschichtung durch Metalle eignet sich besonders Aluminium. Für die Abscheidung von keramischen Materialien sind insbesondere Siliziumoxide oder Aluminiumoxide besonders geeignet. In einer Ausführung des erfinderischen Gegenstandes ist daher vorgesehen, dass die Beschichtungskammer Mittel zum Abscheiden einer keramischen Barriereschicht auf die Folienbahn aufweist.

Es kann weiter vorgesehen sein, dass die Beschichtungskammer eine Ionenquelle zur Vorbehandlung der Trägerfolie aufweist, wobei es sich um eine Ionenquelle von Edelgasen wie z. B. Argon und/ oder reaktiven Gasen wie z. B. Gase von Kohlenwasserstoffen und ungesättigten Kohlenwasserstoffen, Sauerstoff, Stickstoff und gasförmige Stickstoffverbindungen, Halogene, Ammoniak, Lachgas, Ethylenoxid usw. handelt. Vorzugsweise wird für eine Folienvorbehandlung eine Argon-Sauerstoff-Ionenquelle gewählt, wobei insbesondere ein oder mehrere Ionenquellen für die Vorbehandlung der Folienbahn vorgesehen sind. Die Behandlung erfolgt vorteilhafterweise von einer Seite der Folie, der Beschichtungsseite. Die Mittel zur Vorbehandlung der Folie sind vorteilhafterweise in der Beschichtungskammer angeordnet. Unter reaktiven Gasen werden solche Gase verstanden, die nach der Ionisation befähigt sind chemische Verbindungen mit dem Folienmaterial einzugehen. Demgegenüber sind Edelgase zu unterscheiden. Edelgase sind in ihrer ionisierten Form zwar befähigt das Folienmaterial, insbesondere die Oberfläche des Folienmaterials chemisch zu verändern, die Edelgase sind selbst aber nicht befähigt stabile chemische Verbindungen mit dem Folienmaterial einzugehen.

Zusätzlich weist die Beschichtungskammer eine Beschichtungszone auf in der eine oder mehrere Ionenquellen zur Unterstützung der Abscheidung des keramischen Barrierematerials auf die Trägerfolie angebracht sind. Zur Erzeugung von ionisierten Gasen wird bevorzug auf ein Argon/ Sauerstoff Gemisch zurückgegriffen.

Des Weiteren ist denkbar, dass in der Beschichtungskammer wenigstens ein Abscheidematerial oder Verdampfungsmaterial zur Abscheidung einer keramischen Barriereschicht z.B. einer Aluminumoxidschicht oder einer Siliziumoxidschicht vorgesehen ist. Bevorzugt ist ein Verdampfungsmaterial auf Basis von Silizium und Sauerstoff insbesondere ein Gemisch aus Silizium (Si), Siliziumsuboxiden (SiOx) oder Siliziumdioxid ($SiO_2$), mittels dessen Si und/oder SiOx verdampfbar und auf die Folienbahn abscheidbar ist. Vorzugsweise erfolgt eine Verdampfung eines Silizium-/ Siliziumoxidgemisches bei einer Temperatur von 1000 °C bis 1500 °C, 1250 °C bis 1500 °C, 1200 °C $\pm$ 100 °C, 1300 °C $\pm$ 100 °C, insbesondere 1250 °C. Insbesondere ist denkbar, dass als Ausgangsmaterial für eine Beschichtung eine Mischung aus Si und $SiO_2$ in einem Mischungsverhältnis von z. B. 50:50 gewählt wird. Dieses Mischungsverhältnis kann aber grundsätzlich variabel sein und den Anforderungen entsprechend gewählt werden. Alternative Abscheideverfahren von keramischen Barrierematerialien mit denen keramische Gasbarriereschichten erzeugt werden können sind Sputtern, Plasma enhanced chemical vapor deposition (PECVD), und Physical vapor deposition (PVD).

Für bevorzugte Abscheideverfahren von keramischen Siliziumschichten wird als Ausgangsmaterial ein Gemisch von Siliziumoxiden (SiOx) verwendet, wobei bezüglich der stöchiometrischen Zusammensetzung der Siliziumoxide gilt: SiOx mit x = 0 bis 2; vorzugsweise mit x = 0,5 bis 1,7 oder x = 0,7 bis 1,3 oder x = 0,9 $\pm$ 0,2 oder x = 1,0 $\pm$ 0,2 oder 1,1 $\pm$ 0,2 oder x = 1,7 $\pm$ 0,2. Daneben ist denkbar, dass wesentliche Anteile von elementaren Si oder $SiO_2$ im Gemisch mit Siliziumoxiden vorliegen.

Außerdem ist möglich, dass in oder außerhalb der Beschichtungskammer wenigstens ein Mittel zur Messung der Beschichtungsdicke und/oder wenigstens eine gekühlte Beschichtungswalze vorgesehen ist, wobei die gekühlte Beschichtungswalze vorzugsweise in einem Temperaturbereich von -70 °C bis +70 °C betreibbar ist.

Insbesondere ist vorteilhaft vorgesehen, dass mit der Vorrichtung das Verfahren gemäß einem der Ansprüche 11 bis 17 durchführbar und eine Folie mit den Merkmalen der Ansprüche 18 bis 20 herstellbar ist.

Vorzugsweise ist die Folie gemäß der vorliegenden Erfindung nach einem Verfahren und/oder unter Nutzung einer Vorrichtung gemäß der vorliegenden Erfindung hergestellt. Somit kann die Folie gemäß Anspruch 18 oder 19 und ggf. vorteilhafte Ausführungen der Folie nach einem Verfahren gemäß einem der Ansprüche 11 bis 17 oder gemäß einer sonstigen vorteilhaften Ausgestaltung des Verfahrens und/oder in einer Vorrichtung gemäß einem der Ansprüche 1 bis 10 oder gemäß einer sonstigen vorteilhaften Ausgestaltung der Vorrichtung hergestellt sein.

Des Weiteren betrifft die vorliegende Erfindung ein Verfahren mit den Merkmalen des Anspruchs 11. Danach ist vorgesehen, dass bei einem Verfahren zur Herstellung einer kleberfreien Gasbarrierefolie mit einer vorzugsweise keramischen Barriereschicht die folgenden Schritte umfasst sind:

- gegebenenfalls Extrudieren einer Kunststoffschmelze zu einer Trägerfolie,

- Fördern, insbesondere inline Fördern, der Trägerfolie zu wenigstens einem Schleusensystem,

- Durchschleusen der Trägerfolie durch das Schleusensystem in eine Beschichtungskammer,

- Abscheiden einer Barriereschicht auf die Trägerfolie

- gegebenenfalls ausschleusen der Foliebahn

- Beschichten, insbesondere inline Beschichten, d. h. ohne Unterbrechung der Folienförderung, der vorzugsweise keramischen Barriereschicht durch Auftragen einer Kunststoffschmelze beispielsweise nach einem Schmelzextrusionsbeschichtungsprozess.

Vorteilhafte Ausgestaltungen des Verfahrens sind Gegenstand der Unteransprüche.

Sofern die Folienbahn in der Beschichtungskammer unter vorgesehenen Druckbedingungen mit der Barriereschicht beschichtet werden soll ist vorzugsweise vorgesehen, dass die Folienbahn von einer Hochdruckseite durch das Schleusensystem zu einer Niederdruckseite der Beschichtungskammer gefördert wird.

Bevorzugt erfolgt bei dem erfindungsgemäßen Verfahren eine Herstellung einer Barrierefolie, wobei die Barrierewirkung durch Abscheiden von anorganischen, metallischen oder keramischen Barrierematerialien erfolgt.

Auch durch das Verfahren ergibt sich der der Erfindung gemeinsame, übergeordnete und vorstehend bereits im Detail beschriebene Vorteil und technische Effekt, dass eine kleberfreie vorzugsweise keramische Gasbarriere-Folie unter Verwendung des Prozessschrittes der Extrusionsbeschichtung bereitgestellt werden kann.

Es ist möglich, dass zu Beginn des Verfahrens die Schritte

- Extrudieren wenigstens einer Kunststoffschmelze durch wenigstens eine Extrusionsdüse zur Herstellung wenigstens einer Trägerfolie oder einer Basisfolie und

- Transport der extrudierten Folie zur Beschichtungskammer

inline durchgeführt werden, um die Trägerfolie zu erhalten.

Es kann vorgesehen sein, dass die Fördergeschwindigkeit der Folie mindestens 3 m/min, insbesondere zwischen 30 m/min bis 45 m/min, weiter insbesondere zwischen 30 bis 300 m/min, oder bis zu 240 m/min oder bis zu 150 m/min und darunter, insbesondere maximal 300 m/min, vorzugsweise maximal bis zu 60 m/min beträgt.

Ferner ist möglich, dass das erste und/oder das zweite Schleusensystem wenigstens eine Walzenschleuse und/oder wenigstens eine Schlitzschleuse aufweist.

Darüber hinaus ist denkbar, dass mehrere Absaugkammern vorgesehen sind, die jeweils eine Druckstufe ausbilden und/oder dass nach den Absaugkammern wenigstens eine Entgasungskammer vorgesehen ist.

Das Vakuum kann auch stufenweise durch mehrere Absaugstufen angelegt werden, so dass das Vakuum im gesamten Schleusensystem durch ein Druckgefälle von Atmosphärendruck auf einen bevorzugten Enddruck von $10^{-6}$ mbar entsteht.

Des Weiteren ist es möglich, dass in der Beschichtungskammer eine Folienvorbehandlung durch Bestrahlung mit wenigstens einer Ionenquelle stattfindet, wobei es sich um eine Ionenquelle von Edelgasen wie z. B. Argon und/ oder reaktiven Gasen wie z. B. Gase von Kohlenwasserstoffen und ungesättigten Kohlenwasserstoffen, Sauerstoff, Stickstoff und gasförmige Stickstoffverbindungen, z. B. Ammoniak, Lachgas, Halogene, z.B. Chlor Brom Iod, Fluor, Ethylenoxid usw....handelt. Als reaktive Gase sind solche gas anzusehen, die unter den Beschichtungsbedingungen chemische Verbindungen mit weiteren Reaktionspartnern eingehen können, insbesondere mit dem Beschichtungsmaterial. Vorzugsweise wird für eine Folienvorbehandlung eine Argon-Sauerstoff-Ionenquelle gewählt, wobei insbesondere ein oder mehrere Ionenquellen für die Vorbehandlung der Folienbahn vorgesehen sind. Die Behandlung erfolgt vorteilhafterweise von einer Seite der Folie, der Beschichtungsseite. Die Mittel zur Vorbehandlung der Folie sind vorteilhafterweise in der Beschichtungskammer angeordnet.

Des Weiteren ist denkbar, dass nach dem erfindungsgemäßen Verfahren in der Beschichtungskammer wenigstens ein Abscheidematerial zur Abscheidung einer keramischen Barriereschicht z.B. einer Aluminumoxidschicht oder einer Siliziumoxidschicht vorgesehen ist. Bevorzugt ist die Auswahl eines Verdampfungsverfahrens bei dem ein Gemisch aus Silizium (Si), Siliziumsuboxiden (SiOx) oder Siliziumdioxid ($SiO_2$) verdampft und auf die Folienbahn abgeschieden wird. Vorzugsweise erfolgt eine Verdampfung eines Silizium-/ Siliziumoxidgemisches bei einer Temperatur von 1000 °C bis 1500 °C, 1250 °C bis 1500 °C, 1200 °C $\pm$ 100 °C, 1300 °C $\pm$ 100 °C, insbesondere 1250 °C. Insbesondere ist denkbar, dass als Ausgangsmaterial für eine Beschichtung eine Mischung aus Si und $SiO_2$ in einem Mischungsverhältnis von z. B. 50:50 gewählt wird. Dieses Mischungsverhältnis kann aber grundsätzlich variabel sein und den Anforderungen entsprechend gewählt werden. Ebenso können alternative Verfahren zur Abscheidung eines keramischen Barrierematerials auf eine Kunststoffträgerfolie herangezogen werden. Als alternative Verfahren sind z.B. zu nennen Sputtern, Plasma enhanced chemical vapor deposition (PECVD) oder Physical vapor deposition (PVD).

Es kann vorgesehen sein, dass in der Beschichtungskammer eine Messung der Beschichtungsdicke erfolgt. Eine Kühlung der Folienbahn erfolgt bevorzugt durch Kühlwalzen insbesondere dadurch, dass die Beschichtungswalze in einem Temperaturbereich von -70 °C bis +70 °C temperiert wird.

Darüber hinaus betrifft die vorliegende Erfindung eine Folie mit den Merkmalen des Anspruchs 18. Danach ist vorgesehen, dass eine mehrschichtige Gasbarrierefolie eine monoschichtig oder mehrschichtig aufgebaute Trägerschicht, vorzugsweise Trägerfolie bestehend aus einem oder mehreren thermoplastischen Kunststoffmaterialien, ausgewählt aus der Gruppe der Polyolefine, Polyester, Polyamide oder thermoplastischen Elastomeren (TPE), thermoplastisch elastomeren Polyurethanen (TPU) und thermoplastischen Polyolefinen (TPO) umfasst. Darauf angeordnet ist eine keramische Barriereschicht, im Kontakt mit einer weiteren unverstreckten monoschichtigen oder mehrschichtigen Deckschicht aus Kunststoffmaterialien ausgewählt aus der Gruppe der Polyolefine, Polyester, Polyamide oder thermoplastische Elastomere (TPE) ohne dass zwischen Deckschicht und Barriereschicht eine Klebstoffschicht angeordnet ist.

Die Gruppe der thermoplastischen Elastomere umfasst dabei Styrolblockcopolymere oder thermoplastische Polyolefine (TPO), elastmomere Polymere von Polypropylen (PP), Polyethylen (PE), Polybutylen (PBu) und Polyalphaolefinen. Zu den Polyalphaolefinen zählen Polymere, die z.B. aus Monomeren von Buten, Penten, Hexen, Hepten, Okten oder Dodecaen aufgebaut sind.

Als Trägerschicht oder Trägerfolie wird dabei eine Ausgangsfolie verstanden, auf die die Abscheidung der keramischen Barrierematerialien erfolgt. Als Deckschicht oder Deckfolie wird dabei eine Folienschicht verstanden, die die erzeugte Schicht aus den keramischen Barrierematerialien überdeckt. Trägerschicht und Deckschicht können identisch oder verschieden ausgearbeitet sein, wobei der funktionellen Ausrichtung von Trägerschicht oder Deckschicht im Sinne der Erfindung keine Einschränkung entgegenstehen. Die Bezeichnung von Trägerschicht und Deckschicht erfolgt um die Abfolge der einzelnen Schichten in einem fertigen Folienverbundes entsprechend des Ablaufs bei der Herstellung kenntlich zu machen.

Auch durch die Folie ergibt sich der der Erfindung gemeinsame, übergeordnete Vorteil und technische Effekt, nämlich dass die kleberfreie keramische Gasbarriere-Folie selbst bereitgestellt werden kann, wobei diese erfindungsgemäße Folie unter Verwendung des Prozessschrittes der Extrusionsbeschichtung bereitgestellt werden wird.

Denkbar ist vorteilhafterweise, dass die Trägerschicht 10 bis 300 $\mu$m, insbesondere 20 bis 250 $\mu$m, 10 bis 100 $\mu$m vorzugsweise 30- 100 $\mu$m oder 30- 80 $\mu$m

beträgt und/oder dass die Gasbarriereschicht eine keramische Schicht bestehend aus Siliziumsuboxiden (SiOx),insbesondere ein Siliziumsuboxid SiOx mit x= 1,2 bis 1,9 oder 1,3 bis 1,8 oder 1,4 bis 1,7 insbesondere 1,7 oder Aluminiumoxiden (AlOx), ist und eine Dicke von 10 bis 500 nm, 30 bis 300 nm, 15 bis 150 nm, insbesondere 30 bis 100 nm, vorzugsweise 50 nm aufweist.

Insbesondere handelt es sich vorteilhafterweise um eine mehrschichtige Gasbarriere-Folie, die mittels einer Vorrichtung gemäß einem der Ansprüche 1 bis 10 und/oder mittels eines Verfahrens gemäß einem der Ansprüche 11 bis 17 hergestellt wurde.

Die Folie umfasst insbesondere eine Trägerschicht und eine Deckschicht, die auf Polyolefinmaterialien und thermoplastischen Elastomeren basieren. Unter Polyolefinmaterialien sind Kunststoffe zu verstehen, die aus Polymeren aufgebaut sind, die olefinische Monomere umfassen. Polymere die durch alpha-Olefinen wie z. B. Propylen, Ethylen, Butylen, Hexen, Octen und weiteren endständig ungesättigten Oelfinen werden als Polyalphaolefine bezeichnet. Insbesondere werden unter dem Begriff auch Copolymere der genannten Monomere, Blends der daraus resultierende Polymeren, Blockcopolymere der genannten Monomere und Blends der daraus resultierenden Blockcopolymere und Polymere, verzweigte Polymere der genannten Polymere und Blends umfassend die aus den Monomeren hergestellten Polymeren, Copolymeren, Blockcopolymeren und verzweigten Polymeren verstanden.

Einzelne Schichten können ebenfalls aus anderen thermoplastischen Materialien aufgebaut sein, wie z. B. aus Polyester oder aus Polyamiden.

Weiterhin können die Trägerfolie oder die Deckfolie oder Schichten dieser Folien thermoplastische Elastomere von Arylblockcopolymeren enthalten. Solche Polymere sind durch polymerchemische Wiederholungseinheiten von Styrol, Propylen, Butylen, Ethylen, Isopren, Butadien blockartig aufgebaut und umfassen z.B. Styrol-Ethylen-Butylen Blockcopolymere (SEBS, SEB), Styrol Isopren Blockcopolymere (SIS), Styrol Ethylen Propylen Blockcopolymere (SEPS, SEEPS). Beispielhafte Schichtaufbauten sind z. B. in der EP 0 739 713 beschrieben.

Des Weiteren betrifft die vorliegende Erfindung eine Verwendung der Vorrichtung zur Herstellung einer kleberfreien Gasbarrierefolie mit den Merkmalen des Anspruchs 21. Danach ist vorgesehen, dass die Vorrichtung gemäß einem der Ansprüche 1 bis 10 zur Durchführung eines Verfahrens gemäß einem der Ansprüche 11 bis 17, insbesondere zur Herstellung einer mehrschichtige Gasbarrierefolie gemäß einem der Ansprüche 18 bis 20 verwendet wird.

Darüber hinaus betrifft die vorliegende Erfindung ein Disposable mit den Merkmalen des Anspruchs 22. Danach ist vorgesehen, dass die Vorrichtung gemäß einem der Ansprüche 1 bis 10 zur Durchführung eines Verfahrens gemäß einem der Ansprüche 11 bis 17 insbesondere zur Herstellung einer mehrschichtigen Gasbarrierefolie gemäß einem der Ansprüche 18 bis 20 verwendet wird.

Das Disposable kann insbesondere ein Folienbeutel zur Einmalverwendung sein, der vorzugsweise für die Aufnahme von medizinischen Lösungen vorgesehen ist.

Weitere Einzelheiten und Vorteile der Erfindung sollen nun anhand eines in der Zeichnung dargestellten Ausführungsbeispiels näher erläutert werden.

Es zeigen

Figur 1:    eine schematische Darstellung des Kombinationsverfahrens zur Beschichtung von Trägerfolien mit einer SiOx-Barriere; und

Figur 2:    eine schematische Darstellung der erfindungsgemäßen Vorrichtung zur Herstellung einer kleberfreien Gasbarrierefolie mit einer keramischen Barriereschicht.

Figur 3:    eine schematische Darstellung eines Aufbaus einer erfindungsgemäßen Kleberfreien Folienverbundes

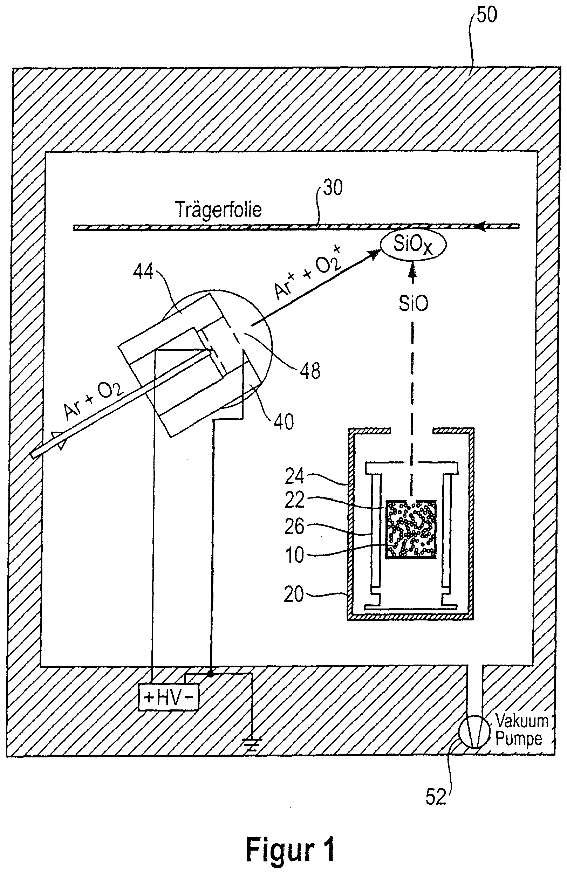

Figur 1 zeigt in schematischer Darstellung das Kombinationsverfahrens zur Beschichtung von einer Folienbahnen, im Folgenden Trägerfolien, mit einer SiOx-Barriere.

Das Ausgangsmaterial Siliciummonoxid (SiO), das als SiO-Granulat 10 in einem Gemisch mit weiteren Siliziumoxid Verbindungen vorliegt, wird in einem mit einem Strahlschutz 24 umgebenen Tiegel 22 mittels eines Heizdrahtes 26 im Hochvakuum auf Temperaturen von 1300 - 1500°C erwärmt, bei denen es in ausreichender Menge in die Gasphase übertritt. Der Dampf schlägt sich auf der über dem Verdampferofen 20 vorbeigeführten Trägerfolie 30 nieder. Die Barriere der so erzeugten SiOx-Schichten ist allerdings noch nicht ausreichend. Gemäß der Erfindung werden hinreichend niedrige Gaspermeabilitäten in Kombination mit einer Ionenquelle 40 (IBAD: ion beam assisted deposition) erzielt. Hierzu wird das auf der Trägerfolie kondensierende Siliziumsuboxid z.B. $SiO_{1,4}$ mit ionisierten Teilchen beschossen. Dies resultiert in einer dichteren und an Defektstellen ärmeren SiOx-Schicht.

Die Ionenquelle 40, die z.B. eine Argon-Sauerstoff-Ionenquelle 40 ist, weist eine Hochspannungsversorgung HV und eine nicht näher bezeichnete Heizung auf. Weiter weist die Ionenquelle 40 eine Anode 44 auf. Dabei stehen $Ar^+$ und $O_2^+$ stellvertretend für jedwede ionisierte Spezies, die sich aus dem Reaktivgas bilden kann. Der gesamte Vorgang findet in einer Vakuumkammer 50 mit einem Druck von $p = 1*10^{-4}$ bis $1*10^{-7}$ mbar statt. Das Vakuum wird durch die Vakuumpumpe 52 angelegt.

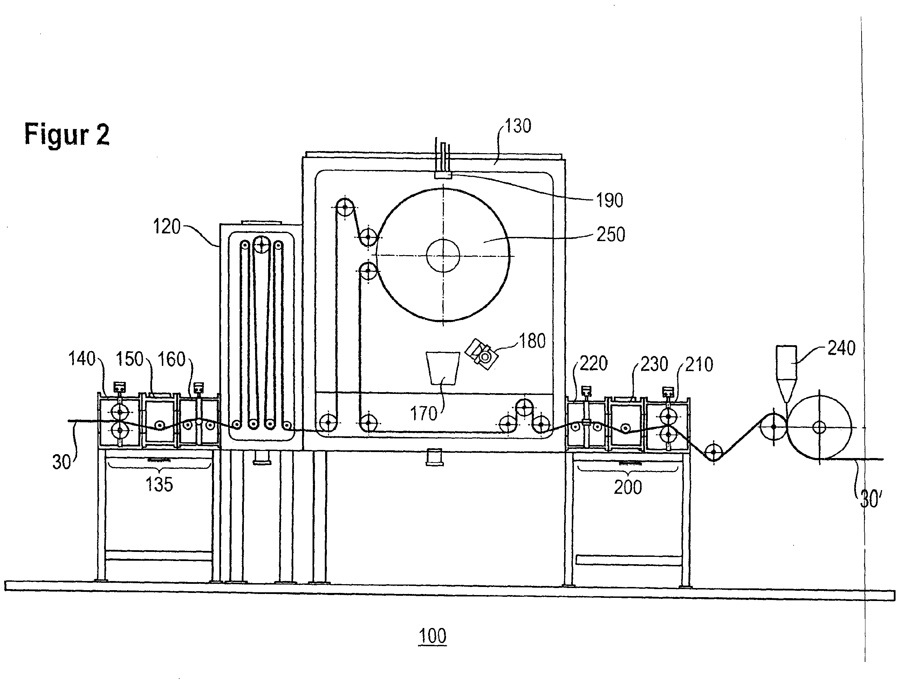

Figur 2 zeigt in schematischer Darstellung die erfindungsgemäße Vorrichtung 100 zur Herstellung einer kleberfreien Gasbarrierefolie mit einer keramischen Barriereschicht.

Die Trägerfolie 30 wird dabei durch die Schleuseneinheit 135 und die Entgasungskammer 120 in die Beschichtungskammer 130 eingeschleust. Nachfolgend dem Schleusenmodul 140 ist ein Absaugmodul 150 vorgesehen gefolgt von einem weiteren Schlitzschleusenmodul 160, um den erforderlichen Prozessdruck zu erreichen. Nach Durchlaufen einer Entgasungskammer 120 gelangt die Folie in die Beschichtungskammer 130, wo die SiOx-Barriereschicht aufgedampft wird. Der SiOx Dampf wird durch einen Verdampferofen 170 in der Beschichtungskammer 130 erzeugt.

In Verbindung mit der IBAD Ionenquelle 180 wird die SiOx-Schicht aufgebracht. Zusätzlich ist eine Vorbehandlung der Folie über eine Ionenquelle 190 vorgesehen bei der die Oberfläche für nachfolgende Prozessschritt aktiviert wird. Eine Messung der Folienspannung erfolgt mittels einer Folienspannungsmesseinrichtungen und eine Messung der Schichtdicke mittels einer Schichtdickenmesseinrichtungen.

Ein guter Kontakt zur Kühlwalze ist unerläßlich, um eine thermische Überbeanspruchung der Trägerfolie zu vermeiden, da die Prozessschritte in der Beschichtungskammer mit einem hohen Wärmeaufkommen verbunden sind, dass die Trägerfolie zerstört werden kann. Je nach Dicke der Folie 30 wird eine Kühlwalzentemperatur von -50°C bis 0°C eingestellt. Abschließend wird die beschichtete Folie 30' wieder über die Schleusenmodule 220, 210 und die Absaugkammer 230 der Schleuseneinheit 200 aus der Beschichtungsanlage 100 ausgeschleust.

Das zweite Beschichtungsmittel mittels dessen die Folienbahn durch Schmelzextrusion zumindest teilweise beschichtbar ist, ist nach der Schleuseneinheit 200 angeordnet und schematisch dargestellt. Ein Extrusionswerkzeug 240 bringt dabei eine Kunststoffschmelze auf die transportierte Folienbahn 30' auf und beschichtet somit inline, d.h. ohne Prozessunterbrechung und innerhalb des laufenden Prozesses, die gerade erzeugte SiOx Schicht.

Dem Prinzip nach erfolgt die Herstellung eines keramischen Gasbarrierefolienverbundes somit im Wesentlichen durch

-    das Extrudieren einer Mono-/Mehrschicht-Trägerfolie,

-    das Einleiten der Folienbahn durch ein Vakuumschleusensystem in eine Beschichtungsanlage,

-    die Beschichtung der Folie mit "Ion beam assisted deposition - IBAD" eines keramischen Materials,

-    das Ausschleusen der Folie durch ein Vakuumschleusensystem und

-    Beschichten des Folienverbundes mit einer mono-/mehrschichtigen Deckschicht durch Schmelzextrusion

Es hat sich gezeigt, dass nach diesem Verfahren auf Kleber verzichtet werden kann. Maßgeblich ist, dass die keramische Beschichtung zeitnah mit der Deckschicht in Verbindung kommt, so dass Alterungsprozesse der keramischen Oberfläche nicht zum Tragen kommen. Die nicht gealterte Oberfläche geht dabei eine gute Verbindung zur schmelzextrudierten Deckschicht ein. Im Gegensatz zum Gegenstand der EP 0 640 474 ergibt sich insbesondere der gewichtige Vorteil, dass das Auftragen der Deckschicht nicht im Vakuum erfolgen muss. Für die Haftung zwischen keramischer Oberfläche und Deckschicht ist es ausreichend, dass die keramisch beschichtete Trägerfolie und die Deckschicht außerhalb der Vakuumkammer inline verbunden werden. Somit wird der gesamten Herstellprozess der Gasbarriereverbundfolie in einem "inline"-Verfahren ausführbar.

Im einfachsten Fall ist die Trägerfolie nur als mechanischer Support für die Gasbarrierefolie vorgesehen. In alternativen Fällen kann die Trägerschicht funktional ausgestaltet sein und wesentliche Anforderungen des Gesamtfolienverbundes im Hinblick auf mechanische Stabilität, optische Qualität, thermischen Eigenschaften übernehmen, die für die Herstellung von Lösungsbeuteln erforderlich sind.

Es kann notwendig sein, dass die Trägerfolie in einem thermisch weitgehend stabilen Zustand vorliegt. ist, d.h., dass die Polymermatierialien nach der Extrusion keinem Prozess der Nachkristallisation unterliegen darf. Eine Nachkristallisation der verwendeten Kunststoffmaterialien nach der Beschichtung mit dem keramischen Barrierematerial kann durch Materialspannungen Defektstellen in der Barriereschicht verursachen. Daher erfolgen nach der Extrusion der Trägerfolie Temperierungsvorgänge, so dass mögliche Kristallisiationsvorgänge innerhalb der Folie ablaufen können bevor die Abscheidung des keramischen Barrierematerials erfolgt.

Im einfachsten Fall kann die Deckschicht nur als Schutzschicht für die keramische Gasbarriereschicht dienen. In alternativen Fällen kann die Deckschicht selbst bereits funktional für die Herstellung von Beutelfolien ausgestaltet sein und mechanische, thermische und optische Anforderungen des Gesamtfolienverbundes übernehmen.

Es ist möglich, dass die Träger- und/oder Deckschichten mono- oder mehrschichtig sind, je nach Funktionalität des gesamten Folienverbundes.

Als Materialien für die Träger- und Deckfolie können Polyolefine, Polyalphaolefine aus Ethylen, Propylen, Butylen, Hexen, Octen, usw., Polypropylen, Polyethylen, SEBS, SIS, SEPS, SEP auch in alternativen Fällen Polyester (PET), Polyamide (PA) gewählt werden.

Im vorliegenden erfindungsgemäßen Verfahren wird durch das Inline-Verfahren direkt ein stabiler Folienverbund durch Trägerfolie, Barriereschicht und Deckschicht erhalten. Zum einen kann so auf verstreckte Trägerfolien verzichtet werden, zum anderen kann der resultierende Folienverbund direkt für die Produktion von Lösungsbeuteln ohne weiter anzustellende Laminierungsverfahren weiterverwendet werden.

Die Dicke der Trägerfolie und oder der Deckfolie kann beispielsweise 10 μm betragen, aber auch bis zu 300 μm für Beutelfolien. Selbstverständlich können sämtliche Dickenwerte zwischen 10 μm bis zu 300 μm

je nach Anwendungszweck gewählt werden. Insbesondere wird als Dickenwert ein Wert zwischen 20 bis 250 μm, oder 10 bis 50 μm vorzugsweise 30 μm gewählt.

Denkbar ist vorteilhafterweise, dass die Trägerschicht 10 bis 300 μm, insbesondere 20 bis 250 μm, 10 bis 100 μm vorzugsweise 30- 100 μm oder 30- 80 μm beträgt und/oder dass die Gasbarriereschicht eine keramische Schicht bestehend aus Siliziumsuboxiden (SiOx),insbesondere ein Siliziumsuboxid SiOx mit x= 1,2 bis 1,9 oder 1,3 bis 1,8 oder 1,4 bis 1,7 insbesondere 1,7 oder Aluminiumoxiden (AlOx), ist und eine Dicke von 10 bis 500 nm 30 bis 300 nm, 15 bis 150 nm insbesondere 30 bis 100 nm, vorzugsweise 50 nm aufweist.

Ein keramisches Beschichten ist prinzipiell auf beiden Seiten der Trägerfolie möglich.

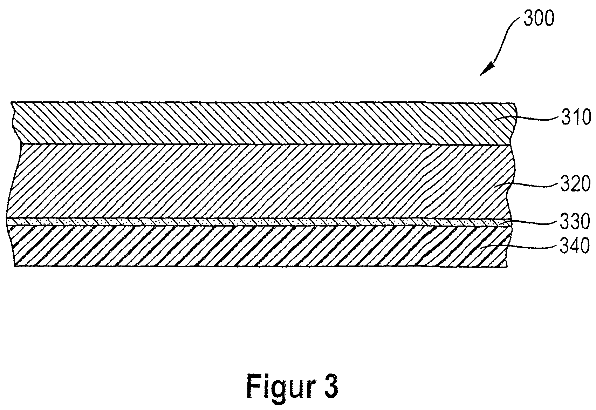

Fig. 3 zeigt einen schematischen Aufbau einer erfindungsgemäßen Folie 300. Die Trägerfolie 340 ist im vorliegenden Beispiel monoschichtig aufgebaut. Im Prozessverlauf wird die Trägerfolie 340 über das Schleusensystem in eine Beschichtungskammer eingeleitet und mit einem keramischen Gasbarrierematerial beschichtet, das sich zu einer dichten Schicht 330 ausbildet. Im vorliegenden Fall steht die Schicht 330 exemplarisch für eine Siliziumoxid Schicht, die durch ein IBAD unterstütztes Gasabscheideverfahren hergestellt wurde. Nach Ausleitung der beschichteten Trägerfolie aus der Beschichtungskammer wird die Deckschicht durch Schmelzextrusionsbeschichtung aufgetragen. Dazu wird eine bereits zweischichtig vorgeprägte Extrusionsschmelze auf die Trägerfolie aufgetragen, die die Deckschichten 320 und 310 bilden.

In der vorliegenden beispielhaften Ausführung ist die Deckschicht zweischichtig ausgeführt, wobei die eine Schicht vorbestimmte Anforderungen der Schweißbarkeit des Folienverbundes erfüllt.

Über die Schicht 320, die als Deckschicht die keramische Barriereschicht 330 überschichtet, werden dabei die wesentlichen Anforderungen an den gesamten Folienverbund in Bezug auf mechanische Stabilität, z.B. Schlagzähigkeit, erfüllt.

Schicht 310 ist so ausgestaltet, dass der Gesamtfolienverbund verschweißt werden kann, insbesondere auch peelbar verschweißt werden kann. Schicht 310 wird in diesem Zusammenhang auch als Siegelschicht bezeichnet.

Die Trägerschicht 340 muss eine steife Basis für die Barriereschicht 330 liefern. Der Folienverbund wird dadurch bezüglich einer hohen Weiterreißfestigkeit, einer hohe Durchstichfestigkeit und einer geringen Dehnung unter Zugspannung geprägt. Weiterhin ist es vorteilhaft wenn über die Trägerfolie eine geringe Verblockungsneigung des Folienverbundes z.B. in der Konstruktion eines Lösungsbeutels zeigt. Unter Verblockungsneigung wir hierunter das Verhalten von Folien verstanden an glatten Oberflächen unter Druckeinwirkung anzuhaften.

Alternativ kann auch eine in Fig 3 nicht gezeigte Haftvermittlerschicht zwischen Barriereschicht 330 und der Deckschicht 320 angeordnet sein. Haftvermittlerschichten, die durch Extrusionsbeschichtung aufgetragen werden sind weitläufig bekannt.

Trägerschicht 340 und Siegelschicht 310 bilden äußere Schichten des Folienverbundes. In einem aus Folie 300 hergestellten Lösungsbeuteln bildet die Siegelschicht 310 eine dem Beutelinhalt zugewandte Seite aus. Die Trägerschicht 340 bildet in einem solchen Beutel die Außenseite.

Ein beispielhafter Aufbau einer erfindungsgemäßen Folie, die frei von Klebstoffen ist zeigt folgenden Aufbau:

Trägerschicht (340):

Schichtdicke: 30 $\mu$m
Formulierung: 100% Homo Polypropylen HD 601 CF Borealis

Barriereschicht (330):

Schichtdicke: 50nm
Formulierung: $SiO_{1,7\pm0,2}$

Deckschicht (220):

Schichtdicke: 130 $\mu$m
Formulierung: 70% Random Copolymer von Polypropylen RD 204 CF Borealis
30% SEBS Kraton G 1652

Siegelschicht (210):

Schichtdicke 20 $\mu$m
Formulierung: 80% Random Copolymer von Polypropylen RD 204 CF
20 % SEBS Kraton G 1652

Der beispielhaft genannte Schichtenverbund liefert eine gebrauchsfertige Gasbarrierefolie, die z.B. in Verpackungsmitteln von Lebensmitteln oder Pharmazeutika Verwendung finden kann.

Die in Figur 2 gezeigte Vorrichtung kann noch wie folgt vorteilhaft ausgestaltet sein:

Das Schleusenmodul kann eine Walzenschleuse 140 aufweisen, in der die Folie zwischen Walzen durchgeführt wird und die an den Seiten abgedichtet ist. Es ist nicht zwingend erforderlich, dass eine Anpressung zwischen den Walzen stattfindet.

Ferner ist, wie schematisch in Figur 2 dargestellt eine Schlitzschleusen 160 vorgesehen. Die Folie wird dabei durch einen engen Spalt zwischen zwei Metallplatten durchgeführt. Als Vorteil ergibt sich, dass es keine bewegten Teile der Schleuse gibt, die einer aufwendigen Absichtung benötigen.

Anschließend durchläuft die Folie eine Entgasungskammer 120, in der flüchtige Bestandteile von der Folie getrennt werden. Eine längere Verweildauer der Folie in Entgasungskammer ist erwünscht, so dass im oder am Folienverbund eingeschlossene, gelöste oder adsorbierte flüchtige Substanzen entweichen können.

Zu Einstellung der Verweilzeit der Folien kann vorgesehen sein, dass 6 Meter (variabel, je nach Anlage) Folie durch die Entgasungskammer geführt werden. Die Verweilzeit der Folie durch die Entgasungskammer hängt von den möglichen Folienfördergeschwindigkeit ab. Die Fördergeschwindigkeit der Folie beträgt dabei mindestens 3 m/min, insbesondere zwischen 30 m/min bis 45 m/min, weiter insbesondere zwischen 30 bis 300 m/min, oder bis zu 240 m/min oder bis zu 150 m/min und darunter, insbesondere maximal 300 m/min, vorzugsweise maximal bis zu 60 m/min.

In der Beschichtungskammer erfolgt eine Folienvorbehandlung: Dabei wird mittels einer Ionenquelle (Argon, Sauerstoff und/oder weitere wie bereits genannte Gase) die Folie bestrahlt und die Bildung von Plasma herbeigeführt wird. Hier durch erfolgt eine Reinigung und Oberflächenaktivierung der zu beschichtenden Trägerfolie.

Ferner ist zur Qualitätssicherung und Online-Überprüfung ein Mittel zur Messung der Beschichtungsdicke vorgesehen. Als übliche Schichtdicke werden für eine Si-Ox-Schicht ca. 50 nm gewählt. Möglich ist grundsätzlich, dass eine Dicke von 30 bis 300 nm, insbesondere 30 bis 100 nm, oder 10 bis 300 nm bevorzugt 15 bis 150 nm, vorzugsweise 50 nm gewählt wird.

Ausgangsmaterial für die Beschichtung mit Siliziumoxiden ist vorzugsweise eine Mischung aus Si und $SiO_2$, z.B. im Verhältnis 50:50 und/oder in Mischung mit SiOx. Bezüglich SiOx gilt vorzugsweise: SiOx mit x = 0 bis 2; vorzugsweise mit x = 0,5 bis 1,7 oder x = 0,7 bis 1,3 oder x = 0,9 $\pm$ 0,2 oder x = 1,0 $\pm$ 0,2 oder 1,1 $\pm$ 0,2 oder x = 1,7 $\pm$ 0,2. In der fertigen keramischen Barriereschicht liegt SiOx vorzugweise in einer Stöchiometrie von $SiO_{1,7\pm0,2}$ vor.

Bezüglich der Schichtdicke ist zu bemerken, dass eine zu dünne Schicht zwar flexibel ist, jedoch schlechte Barrierewerte aufweist, während eine zu dicke Schicht gute Barrierewirkung aber spröde Materialeigenschaften mit sich bringt, also das Risiko einer Rissbildung in der Barriereschicht besteht.

Das $Si/SiO_x$ wird verdampft und scheidet sich auf Folie ab. Die Temperatur beträgt dabei 1250 °C bis 1500 °C. Möglich ist grundsätzlich, dass die Abscheidung bei einer Temperatur von 1000 °C bis 1500 °C, 1250 °C bis 1500 °C, 1200 °C $\pm$ 100 °C, 1300 °C $\pm$ 100 °C, insbesondere 1250 °C erfolgt.

Der Abstand Düse zur Folie beträgt dabei 100 mm bis 350 mm. Zu berücksichtigen und vorzubeugen ist der Gefahr durch Folienschmelzen. Durch einen schnelleren Folientransport besteht eine geringe Schmelzgefahr, da hierdurch die Folie während der Exposition in Beschichtungszone ihre Schmelztemperatur nicht erreichen kann.

Es ist denkbar, dass die Beschichtungswalze gekühlt ist bzw. wird und dabei in einem Temperaturbereich von - 70 °C bis + 70 °C betrieben werden kann.

Mittels der IBAD - Quelle wird die Beschichtungsschicht auf der Trägerfolie bestrahlt, wobei IBAD-Ionenquelle Argon und Sauerstoff nutzt. Durch die IBADIonenquelle erfolgt eine Verdichtung der $SiO_x$ - Schicht und eine stöchimetrische Veränderung des Siliziumoxids. Eine vorteilhafte stöchimetrische Zusammensetzung des Siliziumoxids hinsichtlich thermodynamischer Stabilität, optischer Transparenz und Fluiddichtigkeit ist $SiO_{1,2 - 1,9}$

Eine bevorzugte Barrierewirkung für Folien, die für bikarbonathaltige Lösungen eingesetzt wird, soll mindestens eine Permeabilität für $CO_2$ von höchstens

$$Permeabilit\ddot{a}t \leq 20 \, \frac{cm^3(CO_2)}{bar * m^2 * 24h};$$ bevorzugt

$\leq10$; weiter bevorzugt $\leq5$; darüber hinaus bevorzugt $\leq1$ aufweisen, je nach Konzentrationsgehalts des Bikarbonats in Lösung und des Partialdruckes des damit im Gleichgewicht stehenden $CO_2$. Methoden zur Permeabilitätsbestimmung von Folien sind durch Normen dokumentiert. Insbesondere eignen sich z. B. ASTM D1434 oder die DIN 53380.

Im Sinne der Erfindung weisen die erfindungsgemäßen Barrierefolien Werte der Gaspermeabilität, vorzugsweise von kleiner von 20 ml($CO_2$)/bar/m²/24h bzw. 10 ml($CO_2$)/bar/m²/24h, bzw. 5 ml($CO_2$)/bar/m²/24h auf. Für die Sauerstoffbarriere gelten für eine erfindungsgemäße Barrierefolie entsprechende Permeabilitätswerte, die mit den Pearmeabilitätswerten von Sauerstoff in bekannter Weise korrelieren.

**Patentansprüche**

1. Vorrichtung (100) zur Herstellung einer kleberfreien Gasbarrierefolie, umfassend:

   Fördermittel zum Fördern einer Folienbahn,
   ein erstes Schleusensystem (135) zum Einschleusen der Folienbahn (30) in eine Beschichtungskammer (130) der Vorrichtung (100),
   ein erstes Beschichtungsmittel (170) mittels dessen die Folienbahn (30) durch Abscheiden eines Barrierematerials in der Beschichtungskammer (130) beschichtbar ist,
   ein zweites Schleusensystem (200) zum Ausschleusen der Folienbahn (30') aus der Beschichtungskammer (130), und
   ein außerhalb der Beschichtungskammer (130) angeordnetes zweites Beschichtungsmittel (240), mittels dessen die beschichtete Folienbahn (30') durch Extrusion einer Kunststoffschmelze beschichtbar ist,
   **dadurch gekennzeichnet, dass** die Beschichtungskammer (130) eine Beschichtungszone aufweist, in der eine oder mehrere Ionenquellen (40, 180) angeordnet sind, mittels derer die mit dem Barrierematerial versehene Folienbahn (30) derart behandelbar ist, dass durch die Ionenquelle (40, 180) das Barrierematerial auf der Folienbahn (30) bestrahlt wird.

2. Vorrichtung (100) nach Anspruch 1, wobei in der Beschichtungskammer (130) ein niedrigerer Druck vorherrscht als außerhalb der Beschichtungskammer (130) und ein erstes Schleusensystem (135) dafür vorgesehen ist, die Folienbahn (30) von einer Hochdruckseite zu einer Niederdruckseite der Beschichtungskammer (130) einzuschleusen, und das zweite Schleusensystem (200) dafür vorgesehen ist, die Folienbahn (30') von einer Niederdruckseite zu einer Hochdruckseite auszuschleusen, wobei vorzugsweise eine oder mehrere Absaugkammern (150) im ersten Schleusensystem (135) und/ oder eine oder mehrere Absaugkammern im zweiten Schleusensystems (200) vorgesehen sind.

3. Vorrichtung (100) nach einem oder mehreren der vorhergehenden Ansprüche, **dadurch gekennzeichnet, dass** die Vorrichtung (100) eine Extrusionsdüse zum Extrudieren einer Kunststoffschmelze, wobei aus der Kunststoffschmelze die Folienbahn (30) erhalten wird, und eine oder mehrere Walzen zum Fördern der aus der extrudierten Kunststoffschmelze erhaltenen Folienbahn (30) aufweist.

4. Vorrichtung (100) nach einem oder mehreren der vorhergehenden Ansprüche, **dadurch gekennzeichnet, dass** die Folienbahn (30) mit einer Fördergeschwindigkeit von mindestens 3 m/min, insbesondere zwischen 30 m/min bis 45 m/min, weiter insbesondere zwischen 30 bis 300 m/min, oder bis zu 240 m/min oder bis zu 150 m/min und darunter, insbesondere maximal 300 m/min, vorzugsweise bis zu 60 m/min förderbar ist.

5. Vorrichtung (100) nach einem oder mehreren der vorhergehenden Ansprüche, **dadurch gekennzeichnet, dass** das erste Schleusensystem (135) und/oder das zweite Schleusensystem (200) eine Walzenschleuse (140, 210) und/oder eine Schlitzschleuse (160, 220) aufweist.

6. Vorrichtung (100) nach einem oder mehreren der vorhergehenden Ansprüche, **dadurch gekennzeichnet, dass** die Beschichtungskammer (130) Mittel (20) zum Abscheiden einer keramischen Barriereschicht auf die Folienbahn (30) aufweist.

7. Vorrichtung (100) nach einem oder mehreren der vorhergehenden Ansprüche, **dadurch gekennzeichnet, dass** es sich bei der Ionenquelle der Beschichtungszone um eine Ionenquelle von Edelgasen und reaktiven Gasen, insbesondere von Argon und Sauerstoff handelt und/oder dass die Beschichtungskammer (130) eine Ionenquelle (190) zur Folienvorbehandlung aufweist, wobei es sich um eine Ionenquelle (190) von Edelgasen und/ oder reaktiven Gasen, vorzugsweise um eine Ionenquelle (190) von Argon und Sauerstoff handelt.

8. Vorrichtung (100) nach einem oder mehreren der vorhergehenden Ansprüche, **dadurch gekennzeichnet, dass** in der Beschichtungskammer (130) wenigstens ein Verdampfungsmaterial basierend auf Silizium und Sauerstoff insbesondere Si- und/oder SiOx-Verdampfungsmaterial (10) vorgesehen ist, mittels dessen Si- und/oder SiOx verdampfbar und auf die Folienbahn (30) abscheidbar ist und wobei weiter vorzugsweise die Abscheidung bei einer Temperatur von 1000 °C bis 1500 °C oder 1250 °C bis 1500 °C oder 1200 °C $\pm$ 100 °C oder 1300 °C $\pm$ 100 °C, insbesondere 1250 °C, erfolgt.

9. Vorrichtung (100) nach einem oder mehreren der vorhergehenden Ansprüche, **dadurch gekennzeichnet, dass** in der Beschichtungskammer (130) wenigstens eine gekühlte Beschichtungswalze (250) vorgesehen ist, wobei die gekühlte Beschichtungswalze (250) vorzugsweise in einem Temperaturbereich von -70 °C bis +70 °C betreibbar ist.

10. Verfahren zur Herstellung einer kleberfreien Gasbarrierefolie umfassend die Schritte:

    gegebenenfalls Extrudieren einer Kunststoffschmelze zu einer Trägerfolie,
    Fördern, insbesondere inline-Fördern, einer Trägerfolie (30) zu einem ersten Schleusensystem (135),
    Durchschleusen der Trägerfolie (30) durch das erste Schleusensystem (135) in eine Beschichtungskammer (130),
    Abscheiden einer Barriereschicht auf die Trägerfolie (30),
    Ausschleusen der Folie (30) durch ein zweites Schleusensystem (200),
    Beschichten, insbesondere inline-Beschichten, der Barriereschicht durch Auftragen einer Kunststoffschmelze außerhalb der Beschichtungskammer (130), **dadurch gekennzeichnet, dass** die Beschichtungskammer (130) eine Beschichtungszone aufweist, in der eine oder mehrere Ionenquellen (40, 180) angeordnet sind, mittels derer die Barriereschicht auf der Folienbahn (30) behandelt wird.

11. Verfahren nach Anspruch 10, **dadurch gekennzeichnet, dass** zu Beginn des Verfahrens die Schritte Extrudieren einer Kunststoffschmelze durch eine Extrusionsdüse zur Herstellung einer Trägerfolie (30) und Fördern der erhaltenen extrudierten Folie (30) zur Beschichtungskammer (130) inline durchgeführt werden, um die Trägerfolie (30) zu erhalten.

12. Verfahren nach Anspruch 10 oder 11, **dadurch gekennzeichnet, dass** die Fördergeschwindigkeit der Folie mindestens 3 m/min, insbesondere zwischen 30 m/min bis 45 m/min, weiter insbesondere zwischen 30 bis 300 m/min, oder bis zu 240 m/min oder bis zu 150 m/min und darunter, insbesondere maximal 300 m/min, vorzugsweise maximal bis zu 60 m/min beträgt

13. Verfahren nach einem oder mehreren der Ansprüche 10 bis 12, **dadurch gekennzeichnet, dass** in dem ersten Schleusensystem (135) eine oder mehrere Absaugkammern (150) vorgesehen sind, die jeweils eine Druckstufe ausbilden und dass nach der mindestens einen Absaugkammer (150) eine Entgasungskammer (120) vorgesehen ist.

14. Verfahren nach einem oder mehreren der Ansprüche 10 bis 13, **dadurch gekennzeichnet, dass** es sich vorzugsweise um eine Ionenquelle (40, 180) von Edelgasen und/oder reaktiven Gasen, insbesondere um eine Ionenquelle (40, 180) von Argon und Sauerstoff handelt und/oder dass in der Beschichtungskammer (130) eine Folienvorbehandlung durch Bestrahlung mit wenigstens einer Ionenquelle (190) stattfindet, wobei es sich vorzugsweise um eine Ionenquelle (190) von Edelgasen und/ oder reaktiven Gasen, insbesondere eine Ionenquelle (190) von Argon und Sauerstoff handelt

15. Verfahren nach einem oder mehreren der Ansprüche 10 bis 14, **dadurch gekennzeichnet, dass** in der Beschichtungskammer (130) Verdampfungsmaterial (10) basierend auf Silizium und Sauerstoff insbesondere Si und/oder SiOx verdampft wird und auf die Folienbahn (30) abgeschieden wird und wobei weiter vorzugsweise die Abscheidung bei einer Temperatur von 1000 °C bis 1500 °C oder 1250 °C bis 1500 °C oder 1200 °C $\pm$ 100 °C oder 1300 °C $\pm$ 100 °C, insbesondere 1250 °C, erfolgt.

16. Verfahren nach einem oder mehreren der Ansprüche 10 bis 15, wobei eine Kühlung der Folienbahn (30) vorzugsweise durch eine Kühlwalze (250) in einem Temperaturbereich von -70 °C bis +70 °C erfolgt.

17. Mehrschichtige kleberfreie Gasbarrierefolie, hergestellt in einer Vorrichtung gemäß einem der Ansprüche 1 bis 9 und/oder gemäß einem Verfahren gemäß einem der Ansprüche 10 bis 16, umfassend
    eine monoschichtig oder mehrschichtig aufgebaute Trägerfolie (340) bestehend aus einem oder mehreren thermoplastischen Kunststoffmaterialien, ausgewählt aus der Gruppe der Polyolefine, Polyester, Polyamide, thermoplastischen Elastomeren, thermoplastischen Urethanen, und thermoplastischen Polyolefinen, wobei die die Trägerschicht (340) vorzugsweise 10 bis 300 μm, insbesondere 20 bis 250 μm, vorzugsweise 30 - 100 μm beträgt,

eine keramische Gasbarriereschicht (330) bestehend aus Siliziumsuboxiden, SiOx, wobei die Gasbarriereschicht (330) eine Dicke von 30 bis 100 nm, vorzugsweise 50 nm aufweist,

eine auf der Barriereschicht (330) angeordnete monoschichtige oder mehrschichtige Deckschicht (310, 320) aus Kunststoffmaterialien ausgewählt aus der Gruppe der Polyolefine, thermoplastischen Elastomeren, Polyester Polyamide oder TPU,

wobei die Deckschicht (310, 320) durch Auftragen einer Polymerschmelze auf die Gasbarriereschicht (330) aufgebracht wird, ohne dass zwischen Deckschicht (310, 320) und Barriereschicht (330) eine Klebstoffschicht angeordnet ist.

## Claims

1. An apparatus (100) for manufacturing an adhesive-free gas barrier film, comprising:

   conveying means for conveying a film web;
   at first lock system (135) for introducing the film web (30) into a coating chamber (130) of the apparatus (100);
   a first coating means (170), by means of which the film web (30) can be coated by depositing a barrier material in the coating chamber (130),
   a second lock system (200) for expelling the film web (30') out of the coating chamber (130); and
   a second coating means (240) arranged outside the coating chamber (130), by means of which the coated film web (30') can be at least partially coated by extrusion of a plastic melt,
   **characterized in that** the coating chamber (130) comprises a coating zone in which one or more ion sources (40, 180) are arranged, by means of which the film web (30) provided with the barrier material can be treated such, that the barrier material on the film web (30) is irradiated by means of the ion source (40, 180).

2. An apparatus (100) in accordance with claim 1, wherein a lower pressure is present in the coating chamber (130) than outside the coating chamber (130) and a first lock system (135) is provided to introduce the film web (30) from a high-pressure side to a low-pressure side of the coating chamber (130) and the second lock system (200) is provided to expel the film web (30') from a low-pressure side to a high-pressure side, wherein preferably one or more suction chambers (150) are provided in the first lock system (135) and/or one or more suction chambers are provided in the second lock system (135).

3. An apparatus (100) in accordance with one or more of the preceding claims, **characterized in that** the apparatus (100) has an extrusion nozzle for extruding a plastic melt, wherein the film web (30) is obtained from the plastic melt; and that it comprises one or more rollers for conveying the film web (30) obtained from the extruded plastic melt.

4. An apparatus (100) in accordance with one or more of the preceding claims, **characterized in that** the film web (30) can be conveyed at a conveying speed of at least 3 m/min, in particular between 30 m/min and 45 m/min, further in particular between 30 and 300 m/min, or up to 240 m/min, or up to 150 m/min and below, in particular a maximum of 300 m/min, preferably up to 60 m/min.

5. An apparatus (100) in accordance with one or more of the preceding claims, **characterized in that** the first lock system (135) and/or the optional second lock system (200) has at least one roller lock (140, 210) and/or at least one slit lock (160, 220).

6. An apparatus (100) in accordance with one or more of the preceding claims, **characterized in that** the coating chamber (130) has means (20) for depositing a ceramic barrier layer on the film web (30).

7. An apparatus (100) in accordance with one or more of the preceding claims, **characterized in that** the ion source of the coating zone is an ion source of noble gases and/or reactive gases, in particular argon and oxygen, and/or that the coating chamber (130)) comprises an ion source (190) for film pretreatment, wherein it is an ion source (190) of noble gases and/or reactive gases, preferably an ion source (190) of argon and oxygen.

8. An apparatus (100) in accordance with one or more of the preceding claims, **characterized in that** at least one evaporation material based on silicon and oxygen, in particular Si evaporation material (10) and/or SiOx evaporation material, is provided in the coating chamber (130) by means of which Si and/or SiOx can be evaporated and deposited on the film web (30), and wherein further preferably the deposition takes place at a temperature from 1000°C to 1500°C or 1250°C to 1500°C or 1200°C ± 100°C or 1300°C ± 100°C, in particular 1250°C.

9. An apparatus (100) in accordance with one or more of the preceding claims, **characterized in that** at least one cooled coating roller (250) is provided in the coating chamber (130), wherein the cooled coating roller (250) is preferably operable in a temperature range from -70°C to +70°C.

**10.** A method of manufacturing an adhesive-free gas barrier film comprising the steps of:

> optionally, extruding a plastic melt to form a carrier film;
> conveying, in particular inline conveying, of a carrier film (30) to a first lock system (135);
> introducing the carrier film (30) through the first lock system (135) into a coating chamber (130);
> depositing a barrier layer onto the carrier film (30);
> coating, in particular inline coating, of the barrier layer by applying a plastic melt outside of the coating chamber (130), **characterized in that** the coating chamber (130) comprises a coating zone, in which one or more ion sources (40, 180) are arranged by means of which the film web (30) is treated on the film web (30).

**11.** The method according to claim 10, **characterized in that** the steps of extruding a plastic melt through an extrusion nozzle for manufacturing a carrier film (30) and
conveying the obtained extruded film (30) to the coating chamber (130) are performed inline at the beginning of the method in order to obtain the carrier film (30).

**12.** The method according to claim 10 or 11, **characterized in that** the conveying speed of the film amounts to at least 3 m/min, in particular between 30 m/min and 45 m/min, further in particular between 30 and 300 m/min, or up to 240 m/min, or up to 150 m/min and below, in particular to a maximum of 300 m/min, preferably to a maximum of up to 60 m/min.

**13.** The method according to one or more of the preceding claims 10 to 12, **characterized in that** one or more suction chambers (150) are provided in the first lock system (135) which each form a pressure stage; and **in that** a degassing chamber (120) is provided downstream the at least one suction chamber (150).

**14.** The method according to one or more of claims 10 to 13, **characterized in that** preferably an ion source (40, 180) of noble gases and/or reactive gases, in particular an ion source (40, 180) of argon an oxygen, and/or that is concerned, and/or that a film pretreatment takes place in the coating chamber (130) by irradiation with at least one ion source (190), wherein the ion source (190) is preferably an ion source of noble gases and/or reactive gases, in particular an ion source (190) of argon and oxygen.

**15.** The method according to one or more of claims 10 to 14, **characterized in that** evaporation material (10) based on silicon and oxygen, in particular Si and/or SiOx, is evaporated in the coating chamber (130) and is deposited on the film web (30), and wherein further preferably the deposition takes place at a temperature of 1000°C to 1500°C or 1250°C to 1500°C or 1200°C +/- 100°C, or 1300°C +/- 100°C, in particular 1250°C.

**16.** A method in accordance with one or more of claims 10 to 15, wherein a cooling of the film web (30) preferably takes place by a cooling roller (250) in a temperature range from -70°C to +70°C.

**17.** A multilayer adhesive-free gas barrier film, produced in a device according to one of claims 1 to 9 and/or according to a method according to one of claims 10 to 16, including:

> a carrier film (340) of a monolayer or multilayer design consisting of one or more thermoplastic synthetic materials, selected from the group of polyolefins, polyesters, polyamides, thermoplastic elastomers, thermoplastic urethanes and thermoplastic polyolefins, wherein the carrier layer (340) preferably amounts to 10 to 300 $\mu$m, in particular 20 to 250 $\mu$m, preferably 30 to 100 $\mu$m, a ceramic gas barrier layer (330) consisting of silicon suboxides, SiOx,
> wherein the gas barrier layer (330) has a thickness of 30 to 100 nm, preferably 50 nm,
> a monolayer or multilayer top layer (310, 320) of synthetic materials selected from the group of polyolefins, thermoplastic elastomers, polyesters or polyamides, TPU, arranged on the barrier layer (330),
> wherein the top layer 8310, 320) is applied by application of a polymer melt onto the gas barrier layer without an adhesive layer being arranged between the top layer (310, 320) and the barrier layer (330).

## Revendications

**1.** Dispositif (100) destiné à la fabrication d'une feuille formant barrière aux gaz, exempte de colle, comprenant :

> des moyens de transport destinés au transport d'une feuille en continu,
> un premier système d'éclusage (135) destiné à faire passer la feuille en continu (30) dans une chambre d'enduction (130) du dispositif (100),
> un premier moyen d'enduction (170) au moyen duquel la feuille en continu (30) peut être enduite dans la chambre d'enduction (130) par dépôt d'un matériau barrière,
> un deuxième système d'éclusage (200) destiné à faire sortir la feuille en continu (30') hors de la chambre d'enduction (130), et

un deuxième moyen d'enduction (240) disposé en dehors de la chambre d'enduction (130), au moyen duquel la feuille en continu (30') enduite peut être revêtue, par extrusion, d'une masse de matière plastique fondue, **caractérisé en ce que** la chambre d'enduction (130) présente une zone d'enduction dans laquelle une ou plusieurs sources d'ions (40, 180) sont disposées, au moyen desquelles la feuille en continu (30) munie du matériau barrière peut être traitée de manière à ce que le matériau barrière soit irradié sur la feuille en continu (30) par la source d'ions (40, 180).

**2.** Dispositif (100) selon la revendication 1, dans lequel dans la chambre d'enduction (130) règne une pression plus basse qu'en dehors de la chambre d'enduction (130), et dans lequel un premier système d'éclusage (135) est ménagé pour faire passer la feuille en continu (30) d'un côté de haute pression vers un côté de basse pression de la chambre d'enduction (130), et dans lequel le deuxième système d'éclusage (200) est ménagé pour faire sortir la feuille en continu (30') d'un côté de basse pression vers un côté de haute pression, de préférence une ou plusieurs chambres d'aspiration (150) étant ménagées dans le premier système d'éclusage (135) et/ou une ou plusieurs chambres d'aspiration étant ménagées dans le deuxième système d'éclusage (200).

**3.** Dispositif (100) selon l'une quelconque ou plusieurs des revendications précédentes, **caractérisé en ce que** le dispositif (100) présente une buse d'extrusion destinée à l'extrusion d'une masse de matière plastique fondue, la feuille en continu (30) étant obtenue à partir de la masse de matière plastique fondue, et présente un ou plusieurs rouleaux destinés à transporter la feuille en continu (30) obtenue à partir de la masse de matière plastique fondue.

**4.** Dispositif (100) selon l'une quelconque ou plusieurs des revendications précédentes, **caractérisé en ce que** la feuille en continu (30) peut être transportée avec une vitesse de transport d'au moins 3 m/min, notamment entre 30 m/min à 45 m/min, en outre notamment entre 30 à 300 m/min, ou jusqu'à 240 m/min ou jusqu'à 150 m/min ou moins, de préférence au maximum jusqu'à 300 m/min, de préférence jusqu'à 60 m/min.

**5.** Dispositif (100) selon l'une quelconque ou plusieurs des revendications précédentes, **caractérisé en ce que** le premier système d'éclusage (135) ou le deuxième système d'éclusage (200) présentent une écluse à rouleaux (140, 210) et/ou une écluse à fentes (160, 220).

**6.** Dispositif (100) selon l'une quelconque ou plusieurs des revendications précédentes, **caractérisé en ce que** la chambre d'enduction (130) présente des moyens de dépôt d'une couche barrière céramique sur la feuille en continu (30).

**7.** Dispositif (100) selon l'une quelconque ou plusieurs des revendications précédentes, **caractérisé en ce que** la source d'ions de la zone d'enduction est une source d'ions de gaz nobles et de gaz réactifs, notamment d'argon et d'oxygène, et/ou **en ce que** la chambre d'enduction (130) présente une source d'ions (190) pour le prétraitement de la feuille, la source d'ions (190) étant une source d'ions (190) de gaz nobles et/ou de gaz réactifs, de préférence une source d'ions (190) d'argon et d'oxygène.

**8.** Dispositif (100) selon l'une quelconque ou plusieurs des revendications précédentes, **caractérisé en ce que** dans la chambre d'enduction (130) est ménagé au moins un matériau d'évaporation à base de silicium et d'oxygène, notamment un matériau d'évaporation Si et/ou SiOx (10), au moyen duquel le Si et/ou le SiOx sont vaporisables et déposables sur la feuille en continu (30), et en outre le dépôt étant réalisé de préférence à une température de 1000°C à 1500°C ou de 1250°C à 1500°C ou de 1200°C $\pm$ 100°C ou de 1300°C $\pm$ 100°C, notamment de 1250°C.

**9.** Dispositif (100) selon l'une quelconque ou plusieurs des revendications précédentes, **caractérisé en ce que** dans la chambre d'enduction (130) est ménagé au moins un rouleau d'enduction (250) refroidi, le rouleau d'enduction (250) refroidi pouvant fonctionner de préférence dans une plage de température de -70°C à +70°C.

**10.** Procédé de fabrication d'une feuille formant barrière aux gaz, exempte de colle, comprenant les étapes :

le cas échéant, extrusion d'une masse de matière plastique fondue en une feuille support, transport, notamment transport en ligne, d'une feuille support (30) vers un premier système d'éclusage (135), passage de la feuille support (30) à travers le premier système d'éclusage (135) dans une chambre d'enduction (130), dépôt d'une couche barrière sur la feuille support (30), sortie de la feuille (30) à travers un deuxième système d'éclusage (200), enduction, notamment enduction en ligne, de la couche barrière par application d'une masse de matière plastique fondue en dehors de la chambre d'enduction (130), **caractérisé en ce que** la chambre d'enduction (130) présente une zone d'enduction dans laquelle une ou plusieurs sources d'ions (40, 180) sont disposées, au moyen desquelles la couche barrière est traitée sur la feuille en continu (30).

11. Procédé selon la revendication 10, **caractérisé en ce qu'**au début du procédé, les étapes extrusion d'une masse de matière plastique fondue au moyen d'une buse d'extrusion pour la fabrication d'une feuille support (30) et transport vers la chambre d'enduction (130) de la feuille (30) extrudée obtenue sont réalisées en ligne afin d'obtenir la feuille support (30).

12. Procédé selon la revendication 10 ou 11, **caractérisé en ce que** la vitesse de transport de la feuille est d'au moins 3 m/min, notamment entre 30 m/min à 45 m/min, en outre notamment entre 30 à 300 m/min, ou jusqu'à 240 m/min ou jusqu'à 150 m/min ou moins, notamment au maximum de 300 m/min, de préférence au maximum jusqu'à 60 m/min.

13. Procédé selon l'une quelconque ou plusieurs des revendications 10 à 12, **caractérisé en ce que** dans le premier système d'éclusage (135), une ou plusieurs chambres d'aspiration (150) sont ménagées, lesquelles forment respectivement un étage de pression, et **en ce qu'**une chambre de dégazage (120) est ménagée en aval de l'au moins une chambre d'aspiration (150).

14. Procédé selon l'une quelconque ou plusieurs des revendications 10 à 13, **caractérisé en ce qu'**il s'agit de préférence d'une source d'ions (40, 180) de gaz nobles et/ou de gaz réactifs, notamment d'une source d'ions (40, 180) d'argon et d'oxygène, et/ou **en ce qu'**un prétraitement de la feuille a lieu dans la chambre d'enduction (130) par irradiation avec au moins une source d'ions (190), la source d'ions (190) étant de préférence une source d'ions (190) de gaz nobles et/ou de gaz réactifs, notamment une source d'ions (190) d'argon et d'oxygène.

15. Procédé selon l'une quelconque ou plusieurs des revendications 10 à 14, **caractérisé en ce que** dans la chambre d'enduction (130), du matériau d'évaporation (10) à base de silicium et d'oxygène, notamment Si et/ou SiOx (10), est évaporé et déposé sur la feuille en continu (30), et en outre le dépôt étant réalisé de préférence à une température de 1000°C à 1500°C ou de 1250°C à 1500°C ou de 1200°C $\pm$ 100°C ou de 1300°C $\pm$ 100°C, notamment de 1250°C.

16. Procédé selon l'une quelconque ou plusieurs des revendications 10 à 15, **caractérisé en ce qu'**un refroidissement de la feuille en continu (30) est réalisé de préférence au moyen d'un rouleau de refroidissement (250) dans une plage de température de -70°C à +70°C.

17. Feuille multicouche formant barrière aux gaz, exempte de colle, fabriquée dans un dispositif selon l'une quelconque des revendications 1 à 9 et/ou selon un procédé selon l'une quelconque des revendications 10 à 16, comprenant :

une feuille support (340) à structure monocouche ou multicouche, constituée d'une ou de plusieurs matières synthétiques thermoplastiques, sélectionnées dans le groupe des polyoléfines, polyesters, polyamides, élastomères thermoplastiques, la couche de support (340) étant de préférence de 10 à 300 $\mu$m, notamment de 20 $\mu$m à 250 $\mu$m, de préférence de 30 à 100 $\mu$m, une couche céramique (330) de barrière aux gaz, constituée de suboxydes de silicium, SiOx, la couche de barrière aux gaz (330) présentant une épaisseur de 30 à 100 nm, de préférence de 50 nm, une couche de recouvrement (310, 320) monocouche ou multicouche, disposée sur la couche barrière (330), constituée de matières plastiques sélectionnées dans le groupe des polyoléfines, élastomères thermoplastiques, polyesters, polyamides ou TPU, la couche de recouvrement (310, 320) étant posée sur la couche de barrière aux gaz (330) par application d'une masse de polymères fondue, sans qu'une couche de colle ne soit disposée entre la couche de recouvrement (310, 320) et la couche barrière (330).

**Figur 1**

Figur 2

300

310

320

330

340

**Figur 3**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 4221800
- EP 0640474 A1
- US 5085904 A
- US 3442686 A
- US 5084356 A
- EP 0739713 A
- EP 0640474 A